# EUROPEAN PATENT APPLICATION

(11) **EP 1 667 206 A1**
(43) Date of publication of application: **07.06.2006**
(21) Application number: 05257178.3
(22) Date of filing: 22.11.2005
(51) Int. Cl.: H01L 21/00, H01G 4/12, H05K 1/16

(54) **Thick-film capacitors and methods of making them**

(30) Priority: 02.12.2004 US 2748
(71) Applicant: E.I. DU PONT DE NEMOURS AND COMPANY, Wilmington Delaware 19898 (US)
(72) Inventor: Borland, William J., Cary North Carolina 27513 (US)
(74) Representative: Towler, Philip Dean

(57) **Abstract**

The invention provides a method of making a capacitor comprising: providing a metallic foil; forming a capacitor dielectric over said metallic foil; forming a first electrode over a portion of said capacitor dielectric, thus forming a component side of said metallic foil; laminating the component side of said metallic foil to a laminate material; and etching said metallic foil outside the boundary of said capacitor dielectric to form a second electrode. Using this method allows the laminate material to prevent etching solutions from coming in contact with and damaging the capacitor dielectric layers.

## Description

### TECHNICAL FIELD

The invention relates to thick film capacitors in general, more particularly to embedded capacitors in printed circuit boards. Still more particularly, the invention relates to embedded capacitors in printed circuit boards made from thick film dielectrics.

### BACKGROUND

The practice of embedding capacitors in printed circuit boards (PCB) allows for reduced circuit size and improved circuit performance. Capacitors are typically embedded in panels that are stacked and connected by interconnection circuitry, the stack of panels forming a printed circuit board. The stacked panels can be generally referred to as "inner layer panels."

Passive circuit components embedded in printed circuit boards formed by fired-on-foil technology are known. "Separately fired-on-foil" capacitors are formed by depositing a thick-film capacitor material layer onto a metallic foil substrate, followed by depositing a top electrode material over the thick-film capacitor material layer and a subsequent firing under copper thick-film firing conditions. The thick-film capacitor material may include high dielectric constant materials, glasses and/or dopants, and should have a high dielectric constant (K) after firing.

After firing, the resulting article may be laminated to a prepreg dielectric layer and the metallic foil may be etched to form the electrodes of the capacitor and any associated circuitry. However, etching solutions common in the printed circuit board industry, such as ferric chloride in hot 2.4 normal hydrochloric acid, may attack and dissolve the capacitor dielectric glass and dopants. Etching solutions damage capacitor dielectrics such that many capacitors may be shorted after etching. Even when shorting has not occurred, the damage to the dielectric may compromise the long term reliability of the capacitor, especially if all of the etching solution has not been thoroughly removed from the capacitor. Other solutions commonly used in the printed circuit board industry for other processes, such as the black oxide process and plating, may also damage capacitor dielectrics and have similar long-term reliability implications.

One solution to the etching problem is to use a high silica content glass in the thick-film capacitor composition that is resistant to etching solutions. High silica glasses, however, have very low dielectric constants and high softening points. When used in capacitor formulations, the high softening points make the resulting compositions difficult to sinter to high density unless large volume fractions of glass are present. High volume fractions of glass, however, result in undesirable low dielectric constants for the resulting dielectric.

A further solution to the etching problem is disclosed in U.S. Patent Application No. 10/882,820 to Borland et al, which discloses a method of making a capacitor comprising: providing a metallic foil; forming a dielectric over the metallic foil; forming a first electrode over a portion of the dielectric; forming a protective coating over a portion of the metallic foil, including the entire dielectric; and etching the metallic foil to form a second electrode. Borland et al. further discloses a method of making a printed circuit board which comprises forming a dielectric over a metallic foil, forming a first electrode over the dielectric, laminating a non-component side of the metallic foil to at least one dielectric material, forming a protective coating over at least a part of the dielectric, and etching the metallic foil to form a second electrode.

The present inventor desired to provide a unique solution to this etching problem by creating novel methods of making capacitors and printed circuit boards. The inventor has accomplished such a goal by developing a design approach that prevents the etching solutions from reaching the capacitor dielectric.

### SUMMARY OF THE INVENTION

According to a first embodiment, a method of making a capacitor comprises: providing a metallic foil; forming a capacitor dielectric over the metallic foil; forming a first electrode over a portion of the capacitor dielectric; laminating the component side of the metallic foil to a laminate material and etching the metallic foil in a manner to avoid the acid coming in contact with the capacitor dielectric to form a second electrode.

According to the above embodiment, the design allows the laminate material to protect the capacitor dielectric from etching solutions used during fabrication. The etching solutions would otherwise attack and dissolve the capacitor dielectric glasses and dopants present in the dielectric. Capacitor reliability and performance are thereby improved, and shorts of the capacitor are avoided. Also, etch resistant glasses, which reduce the resultant dielectric constant of the dielectric, are not required in the fabrication processes according to the present embodiments.

Those skilled in the art will appreciate the above stated advantages and other advantages and benefits of various additional embodiments of the invention upon reading the following detailed description of the embodiments.

### BRIEF DESCRIPTION OF THE DRAWINGS

The detailed description will refer to the following drawings wherein:
FIGS. 1 A-1 H are a series of views illustrating a first method of manufacturing a multilayer printed circuit board with embedded capacitors having a single-layer capacitor on metallic foil design.
FIG. 2 represents the top view of a single dielectric layer capacitor.
FIGS. 3A-3G are a series of views illustrating a method of manufacturing a printed circuit board with embedded capacitors having a double-layer capacitor on metallic foil design.
Figure 4 represents the top view of a double dielectric layer capacitor.
According to common practice, the various features of the drawings are not necessarily drawn to scale. Dimensions of various features may be expanded or reduced to more clearly illustrate the embodiments of the invention.

### DETAILED DESCRIPTION OF THE INVENTION

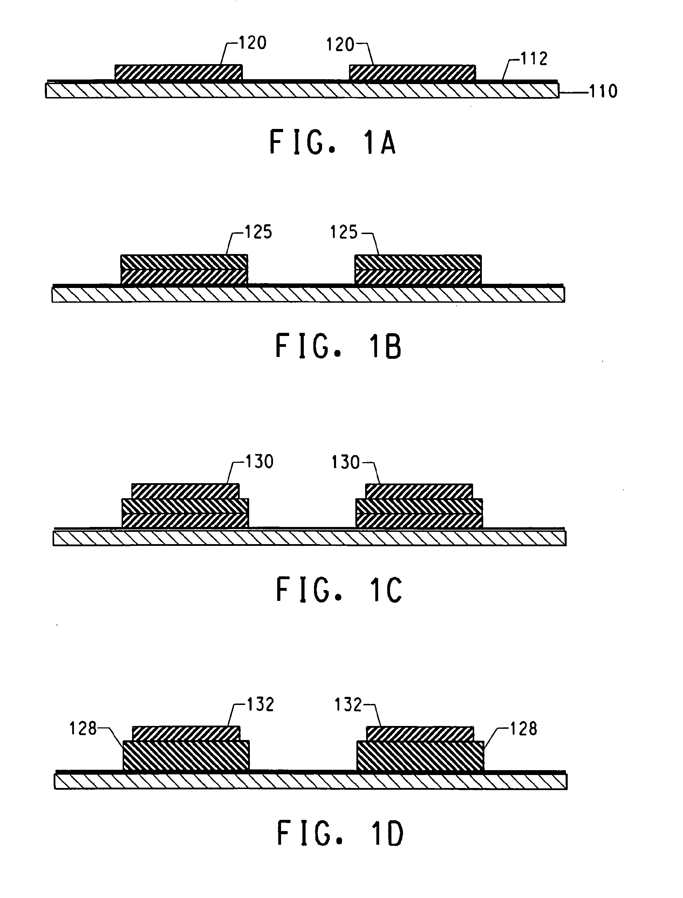

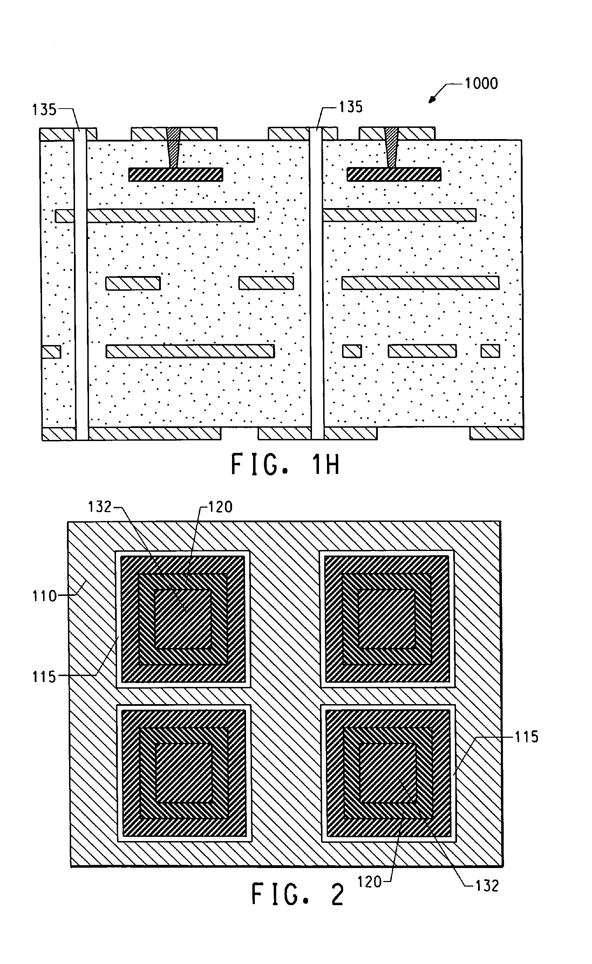

FIGS. 1A-1 H illustrate a first method of manufacturing a multilayer printed circuit board (PCB) 1000 (FIG. 1 H) with embedded capacitors having a single-layer capacitor on metallic foil design. For illustrative purposes, two embedded capacitors are illustrated as formed in the sectional views of FIGS. 1A-1 H. However, one, two, three, or more capacitors can be formed on a foil by the methods described in this specification. The following written description is addressed to the formation of only one of the illustrated capacitors for the sake of simplicity.

In FIG. 1A, a metallic foil 110 is provided. The metallic foil 110 may be of a type generally available in the industry. For example, the metallic foil 110 may be copper, copper-invar-copper, invar, nickel, nickel-coated copper, or other metals and alloys that have melting points that exceed the firing temperature for thick film pastes, such as 900°C. Suitable foils include foils comprised predominantly of copper, such as reverse treated copper foils, double-treated copper foils, and other copper foils commonly used in the multilayer printed circuit board industry. The thickness of the metallic foil 110 may be in the range of, for example, about 1-100 microns. Other thickness ranges include 3-75 microns, and more specifically 12-36 microns. These thickness ranges correspond to between about 1/3 oz and 1 oz copper foil.

The foil 110 may optionally be pretreated by applying an underprint 112 to the foil 110. The underprint 112 is shown as a surface coating in FIG. 1A, and may be a relatively thin layer applied to the component-side surface of the foil 110. The underprint 112 adheres well to the metal foil 110 and to layers deposited over the underprint 112. The underprint 112 may be formed, for example, from a paste applied to the foil 110 that is fired at a temperature below the melting point of the foil 110. The underprint paste may be printed as an open coating over the entire surface of the foil 110, or printed over selected areas of the foil 110. It is generally more economical to print the underprint paste over selected areas of the foil 110 rather than over the entire foil 110. However, it may be preferable to coat the entire surface of the foil 110 if oxygen-doped firing is used in conjunction with a copper foil 110, because glass content in the underprint retards oxidative corrosion of the copper foil 110.

One thick-film paste suitable for use as an underprint has the following composition (amounts relative by mass):

| | |
|---|---|
| Copper powder | 58.4 |
| Glass A | 1.7 |
| Cuprous oxide powder | 5.8 |
| Vehicle | 11.7 |
| TEXANOL® solvent | 12.9 |
| Surfactant | 0.5 |
| Total | 91.0 |

| | | |
|---|---|---|
| In this composition, | | |
| Glass A comprises: lead germanate of the composition Pb₅Ge₃O₁₁ | | |
| Vehicle comprises: | Ethyl cellulose N200 | 11 % |
| | TEXANOL® | 89% |
| Surfactant comprises: VARIQUAT® CC-9 NS surfactant | | |

TEXANOL® is available from Eastman Chemical Co. VARIQUAT® CC-9 NS is available from Ashland Inc.

A capacitor dielectric material is deposited over the underprint 112 of the pretreated foil 110, forming a first dielectric material layer 120 (FIG. 1A). The capacitor dielectric material may be, for example, a thick-film capacitor paste that is screen-printed onto the foil 110. The first dielectric material layer 120 is then dried. In FIG. 1 B, a second dielectric material layer 125 is then applied, and dried. In an alternative embodiment, a single layer of capacitor dielectric material may be deposited to an equivalent thickness of the two layers 120, 125, in a single screen printing step. One suitable thick-film capacitor dielectric material disclosed for use in fired-on-foil embodiments has the following composition (amounts relative by mass):

| | |
|---|---|
| Barium titanate powder | 68.55 |
| Lithium fluoride | 1.0 |
| Barium fluoride | 1.36 |
| Zinc fluoride | 0.74 |
| Glass A | 10.25 |
| Glass B | 1.0 |
| Glass C | 1.0 |
| Vehicle | 5.9 |
| TEXANOL® solvent | 8.7 |
| Oxidizer | 1.0 |
| Phosphate wetting agent | 0.5 |
| Total | 100.00 |

| | | |
|---|---|---|
| In this composition, | | |
| Glass A comprises: lead germanate of the composition Pb₅Ge₃O₁₁ | | |
| Glass B comprises: | Pb₄BaGe_{1.5} Si_{1.5} O₁₁ | |
| Glass C comprises: | Pb₅GeSiTiO₁₁ | |
| Vehicle comprises: | Ethyl cellulose N200 | 11 % |
| | TEXANOL® solvent | 89% |
| Oxidizer comprises: | Barium nitrate powder | 84% |
| | Vehicle | 16% |

In FIG. 1C, a conductive material layer 130 is formed over the second dielectric material layer 125, and dried. The conductive material layer 130 can be formed by, for example, screen-printing a thick-film metallic paste over the second dielectric material layer 125. The paste used to form the underprint 112 is also suitable for forming the conductive material layer 130. The surface area of the first and second dielectric layers 120, 125, when viewed from a top plan perspective, is larger than that of the conductive material layer 130.

The first dielectric material layer 120, the second dielectric material layer 125, and the conductive material layer 130 are then co-fired to sinter the resulting structure together. The post-fired structure section is shown in front elevation in FIG. 1 D. Firing results in a single dielectric 128 formed from the dielectric layers 120 and 125, because the boundary between the dielectric layers 120 and 125 is effectively removed during co-firing. A top electrode 132 also results from the co-firing step. When fired on copper foil in nitrogen at 900°C for 10 minutes at peak temperature, the resulting dielectric 128 may have a dielectric constant of between about 3000 and 5000 and a dissipation factor of approximately 2.5%. Alternative firing conditions may be used to obtain differing material properties for the dielectric 128.

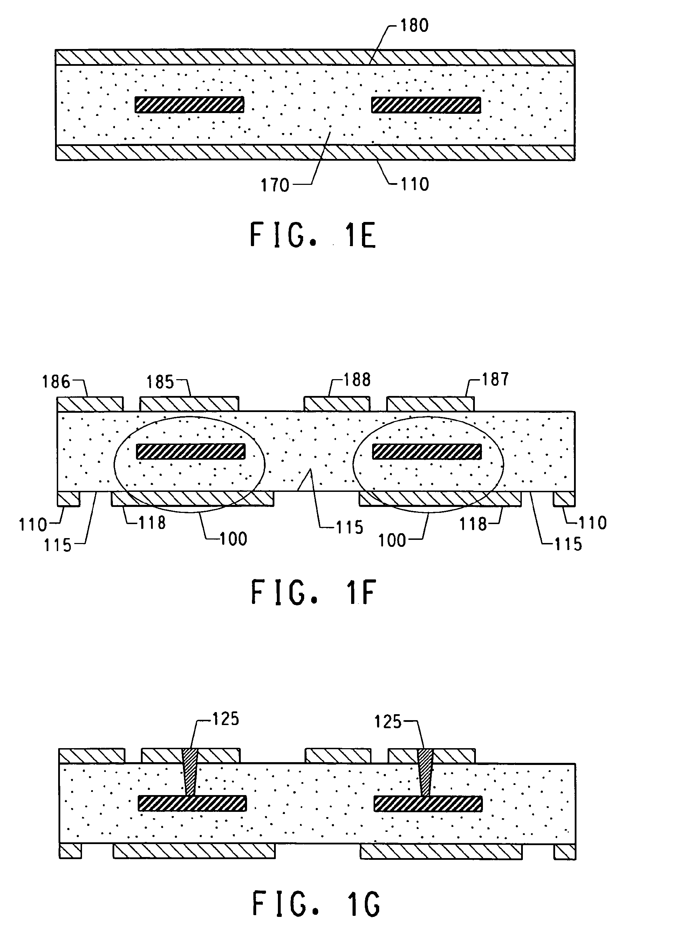

In FIG. 1 E, the component surface of the foil 110 is laminated with laminate material 170 with the top electrode 132 face up. The resulting structure is an innerlayer panel. The lamination can be performed, for example, using FR4 prepreg in standard printing wiring board processes. In one embodiment, 106 epoxy prepreg may be used. Suitable lamination conditions, for example, are 185°C at 208 psig for 1 hour in a vacuum chamber evacuated to 28 inches of mercury (95 kPa). Lamination conditions may vary due to material selection. A silicone rubber press pad and a smooth PTFE-filled glass release sheet may be in contact with the foil 110 to prevent the epoxy from gluing the lamination plates together. The laminate material 170 can be any type of dielectric material such as, for example, standard epoxy, high Tg epoxy, polyimide, polytetrafluoroethylene, cyanate ester resins, filled resin systems, BT epoxy, and other resins and laminates that provide insulation between circuit layers. A foil 180 may be applied to an opposite side of the laminate material 170 to provide a surface for creating circuitry.

Referring to FIG. 1 F, after lamination, a photoresist is applied over the metallic foils 110 and 180 and is imaged and developed. The metallic foils 110 and 180 are etched and the remaining photoresist stripped using, for example, standard printed wiring board conditions. The etching forms a trench 115 in the foil 110 outside of the periphery of the capacitor dielectric 128 and results in a capacitor foil electrode 118 that is isolated from the remainder of the metallic foil 110. The capacitor foil electrode 118, the dielectric 128, and the top electrode 132 form a capacitor 100. The etching process also creates circuitry 185, 186, 187, 188, etc. from the foil 180. During the etching process, the etching solution does not come into contact with the capacitor dielectric material of the capacitor 100 because the area of the capacitor foil electrode, 118, is larger than that of the capacitor dielectric and the laminate 170 covers the dielectric of the capacitor structure 100.

Referring to FIG. 1 G, a microvia 125 may be laser drilled and plated to electrically connect the electrode 132 with the outer (or surface) circuitry 185 and 187 to form a completed inner layer. Forming the microvia at this stage allows for additional laminates to be laminated to either side of the inner layer. Alternatively, if laminates are only going to be laminated to the foil electrode side of the inner layer, the microvia 125 can be formed at the same time as the via 135 shown in FIG. 1 H.

Referring to FIG. 1H, additional laminates and etched copper foil pairs may be laminated to either side of the inner layer shown in FIG. 1 G. In this example, they are laminated to one side only.

A via 135 may be drilled and plated to electrically connect the bottom or foil electrode 118 to the outer circuitry 186, 188 in order to complete the electrical connections of the capacitor 100. An additional via may also be formed to electrically connect to the second capacitor 100 shown in FIG. 1 H. Top surfaces of the printed circuit board 1000 may be plated with tarnish resistant metals to complete the printed circuit board 1000.

The finished circuit board 1000 in FIG. 1 H is a four metal layer printed wiring board with the embedded capacitors 100 in the layer adjacent to the outer layer of the printed circuit board 1000. However, the printed wiring board 1000 may have any number of layers and the embedded capacitors according to the present embodiments can be located at any layer in a multilayer printed circuit board. Microvias may also be used to connect circuitry with the capacitor foil electrode 118, as an alternative to plated through-hole vias.

In the above embodiment, during the etching process, the etching solution does not come into contact with the capacitor dielectric material of the capacitor 100. Reliability of the capacitor 100 is thereby increased. In addition, the possibility of shorting of the finished capacitor 100 is greatly reduced.

FIG. 2 represents the top view of a single dielectric layer capacitor. The single dielectric layer, 120, is apparent on the metallic foil, 110. A conductive material layer, upon firing, forms a top electrode, 132, over the dielectric layer, 120. Etching forms a trench, 115 in the foil, 110, outside of the periphery of the capacitor dielectric, 120, and results in a capacitor foil electrode, 118, that is isolated from the remainder of the metallic foil, 110. The capacitor foil electrode 118, the dielectric 120, and the top electrode 132 form a capacitor 100.

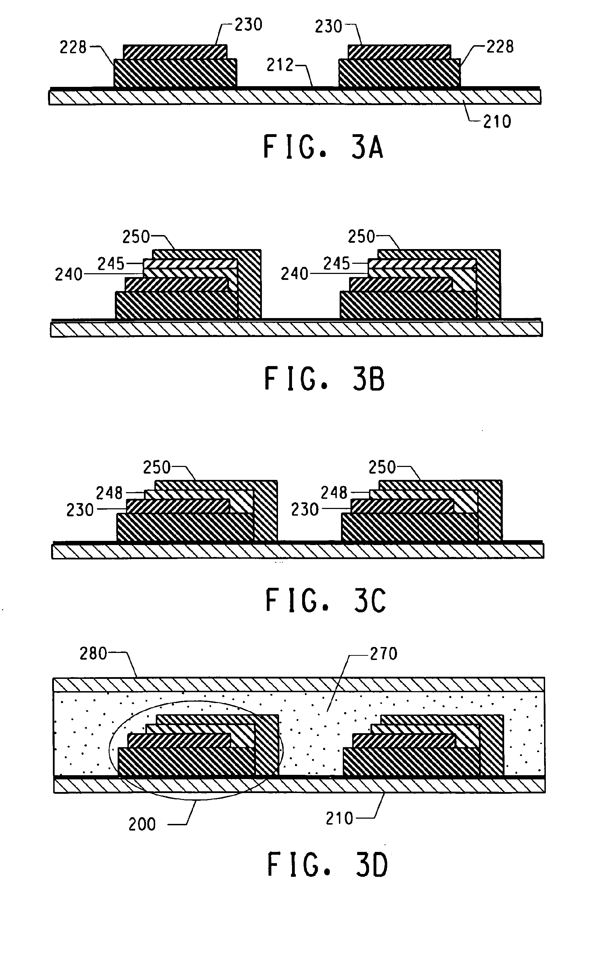

FIGS. 3A-3G illustrate a method of manufacturing a printed circuit board 2000 (FIG. 3G) with embedded capacitors 200 having two layers of dielectric and three electrodes. The description below discusses the formation of one capacitor 200 for simplicity. FIGS. 3A-3G are sectional views in front elevation.

In FIG. 3A, the article as shown in FIG 1 D is prepared.

Referring to FIG. 3B, a third dielectric material layer 240 is formed over the electrode 230, and dried. A fourth dielectric material layer 245 is formed over the third dielectric material layer 240, and dried, and a second conductive material layer 250 is formed over the fourth dielectric material layer 245, and dried. The resulting article is then fired. FIG. 3C shows the post-fired article. Firing results in a two-layer dielectric 248 formed from the dielectric layers, and a top electrode 250 that is electrically isolated from the middle electrode 230 and electrically connected to the foil 210.

Referring to FIG. 3D, the component side of the foil 210 is laminated with laminate material 270 under similar conditions to the processes described above with reference to FIG. 1 E. The foil 210 may be laminated such that the capacitor structures are on the inside of the innerlayer panel structure. A foil 280 may be applied to the laminate material 270 to provide a surface for creating circuitry (surface circuitry). The laminate material together with the foil is termed the laminate foil pair. The resulting structure is an innerlayer panel.

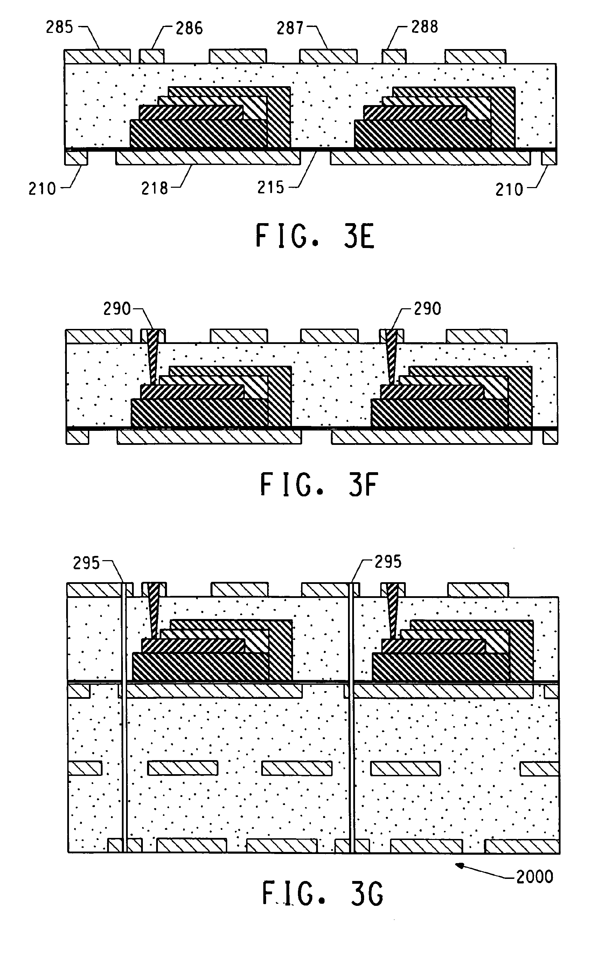

Referring to FIG. 3E, after lamination, a photoresist is applied over the foils 210 and 280, and is imaged and developed. The foils 210 and 280 are then etched and remaining photoresist stripped to form a trench 215 in the foil 210 that is outside the periphery of the capacitor dielectric 248 and results in a bottom or capacitor foil electrode 218 that is isolated from the remainder of the foil. The capacitor foil electrode 218, the two-layer dielectric 248, the middle electrode 230, and the top electrode 250 form a capacitor 200. The etching process also creates circuitry 285, 286, 287, 288, etc. from the foil 280. During the etching process, the etching solution does not come into contact with the capacitor dielectric material of the capacitor 200 because the area of the electrode is larger than that of the dielectric and the laminate 270 covers the dielectric of the capacitor structure 200.

Referring to FIG. 3F, a micro-via 290 may be laser drilled and plated to connect the middle electrode 230 with the circuitry 286 to form a completed inner layer panel. Forming the microvia at this stage allows for additional laminates to be laminated to either side of the inner layer. Altematively, if laminates are only going to be laminated to the foil electrode side of the inner layer, the microvia 290 can be formed at the same time as the via 295 as shown in FIG 3G.

Referring to FIG. 3G, additional laminates and etched copper foil layer pairs may be laminated to one or both sides of the innerlayer panel structure of FIG. 3F. In this example, they are laminated to one side only.

A via 295 may be drilled and plated to connect the bottom or foil electrode 218 to the outer circuitry 285, and other circuitry in order to complete the electrical connections of the capacitor 200. Additional vias may also be formed to connect to the other capacitor 200. Top copper surfaces of the printed circuit board 2000 may be plated with tarnish resistance metals to complete the module 2000.

The finished printed circuit board 2000 illustrated in FIG. 3G is a four metal layer printed circuit board with the embedded capacitors 200 located in the layer adjacent to the outer layer of the printed circuit board 2000. However, the printed wiring board 2000 may have any number of layers, and embedded capacitors according to the present embodiments can be placed at any layer in a multilayer printed circuit board. Microvias may also be used to connect circuitry with the capacitor foil electrode 218 as an alternative to plated through hole vias.

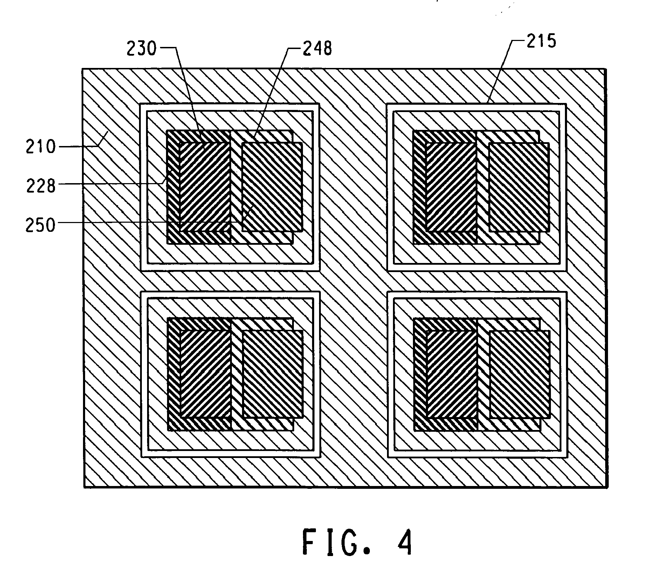

Figure 4 represents the top view of a double dielectric layer capacitor. The initial dielectric layer, 228, is apparent on top of the metallic foil, 210. A conductive material layer, upon firing, forms a top electrode, 230, over the dielectric layer, 228. One or more dielectric material layers are formed over the top electrode and dried, as a second conductive material layer, 250 is formed over the dielectric material layer(s). Firing results in a two-layer dielectric, 248, formed from the initial dielectric layer 228 and additional dielectric layers. Etching forms a trench, 215 in the foil, 210, outside of the periphery of the capacitor dielectric, 228 and 248.

The two-layer capacitor 200 provides very high capacitance densities. For example, a two-layer capacitor can provide almost double the capacitance density of a single-layer capacitor.

In the above embodiment, the capacitor dielectric does not come into contact with etching solution during fabrication. The dielectric is therefore not subjected to acid etching solutions which would otherwise attack and dissolve the dielectric glasses and dopants in the dielectrics. Capacitor reliability and performance are thereby improved.

In the above embodiments, the thick-film pastes may comprise finely divided particles of ceramic, glass, metal or other solids. The particles may have a size of the order of 1 micron or less, and may be dispersed in an "organic vehicle" comprising polymers dissolved in a mixture of dispersing agent and organic solvent.

The thick-film dielectric materials may have a high dielectric constant (K) after firing. For example, a high K thick-film dielectric may be formed by mixing a high dielectric constant powder (the "functional phase"), with a glass powder and dispersing the mixture into a thick-film screen-printing vehicle. During firing, the glass component of the capacitor material softens and flows before the peak firing temperature is reached, coalesces, and encapsulates the functional phase forming the fired capacitor composite.

High K functional phases include perovskites of the general formula ABO₃, such as crystalline barium titanate (BT), lead zirconate titanate (PZT), lead lanthanum zirconate titanate (PLZT), lead magnesium niobate (PMN) and barium strontium titanate (BST). Barium titanate is advantageous for use in fired-on copper foil applications since it is relatively resistant to reducing conditions used in firing processes.

Typically, the thick-film glass component of a dielectric material is inert with respect to the high K functional phase and essentially acts to cohesively bond the composite together and to bond the capacitor composite to the substrate. Preferably only small amounts of glass are used so that the dielectric constant of the high K functional phase is not excessively diluted. The glass may be, for example, calcium-aluminum-borosilicates, lead-barium-borosilicates, magnesium-aluminum-silicates, rare earth borates or other similar compositions. Use of a glass with a relatively high dielectric constant is preferred because the dilution effect is less significant and a high dielectric constant of the composite can be maintained. Lead germanate glass of the composition Pb₅Ge₃O₁₁ is a ferroelectric glass that has a dielectric constant of approximately 150 and is therefore suitable. Modified versions of lead germanate are also suitable. For example, lead may be partially substituted by barium and the germanium may be partially substituted by silicon, zirconium and/or titanium.

Pastes used to form the electrode layers may be based on metallic powders of copper, nickel, silver, silver-palladium compositions, or mixtures of these compounds. Copper powder compositions are preferred.

The desired sintering temperature is determined by the metallic substrate melting temperature, the electrode melting temperature and the chemical and physical characteristics of the dielectric composition. For example, one set of sintering conditions suitable for use in the above embodiments is a nitrogen firing process having a 10-minute residence time at a peak temperature of 900°C.

The foregoing description of the invention illustrates and describes the present invention. Additionally, the disclosure shows and describes only selected preferred embodiments of the invention, but it is to be understood that the invention is capable of use in various other combinations, modifications, and environments and is capable of changes or modifications within the scope of the inventive concept as expressed herein, commensurate with the above teachings, and/or within the skill or knowledge of the relevant art.

The embodiments described hereinabove are further intended to explain best modes known of practising the invention and to enable others skilled in the art to utilize the invention in such, or other, embodiments and with the various modifications required by the particular applications or uses of the invention. Accordingly, the description is not intended to limit the invention to the form disclosed herein. Also, it is intended that the appended claims be construed to include alternative embodiments, not explicitly defined in the detailed description.

## Claims

1. A method of making a capacitor comprising:
providing a metallic foil;
forming a capacitor dielectric over said metallic foil;
forming a first electrode over a portion of said capacitor dielectric, thus forming a component side of said metallic foil;
laminating the component side of said metallic foil to a laminate material; and
etching said metallic foil outside the boundary of said capacitor dielectric to form a second electrode.

2. The method of claim 1 further comprising forming a second capacitor dielectric layer over said first electrode and forming a third electrode over said second capacitor dielectric layer, wherein said third electrode is electrically coupled to said second electrode.

3. The method of claim 1 or claim 2 wherein said metallic foil is selected from metals, metal alloys and mixtures thereof with a firing temperature of greater than 900°C.

4. The method of any preceding claim wherein said metallic foil is selected from copper, copper-invar-copper, invar, nickel, and nickel-coated copper.

5. A capacitor obtainable by the method of any preceding claim.

6. The capacitor of claim 5 wherein said capacitor is a two-layer capacitor.

7. A method of making a printed circuit board, comprising:
providing a metallic foil;
forming a capacitor dielectric over said metallic foil;
forming a first electrode over a portion of said capacitor dielectric, thus forming a component side of said metallic foil;
laminating the component side of said metallic foil to at least one laminate foil pair, thus forming an innerlayer panel structure;
etching said metallic foil outside the boundary of said capacitor dielectric to form a second electrode, wherein said first electrode, said capacitor dielectric and said second electrode form a capacitor;
etching said laminate foil pair to form surface circuitry on said innerlayer panel structure;
forming a microvia that connects said first electrode to said surface circuitry of said innerlayer panel structure; and
laminating said innerlayer panel structure to at least one additional laminate material.

8. The method of claim 7 further comprising forming a second capacitor dielectric layer over said first electrode and forming a third electrode over said second capacitor dielectric layer, wherein said third electrode is electrically coupled to said second electrode.

9. The method of claim 7 or claim 8 wherein said laminate foil pair comprises a copper foil.

10. A printed circuit board obtainable by the method of any one of claims 7 to 9.
